# EUROPEAN PATENT SPECIFICATION

(11) **EP 0 238 066 B1**
(45) Date of publication and mention of the grant of the patent: **25.05.1994**
(21) Application number: 87103983.0
(22) Date of filing: 18.03.1987
(51) Int. Cl.: H01L 21/76, H01L 21/58, H01L 21/225

(54) **A method for effecting adhesion of silicon or silicon dioxide plates**
Verfahren zur Ausführung der Adhäsion zwischen Scheiben aus Silizium oder Siliziumdioxid
Procédé pour effectuer l'adhésion entre des disques de silicium ou de dioxyde de silicium

(30) Priority: 18.03.1986 JP 59744/86
(43) Date of publication of application: 23.09.1987
(73) Proprietor: FUJITSU LIMITED, Kawasaki-shi, Kanagawa 211 (JP)
(72) Inventor: Muto, Masaaki FUJITSU LIMITED Patent Department, Nakahara-ku Kawasaki-shi Kanagawa 211 (JP); Kato, Takashi FUJITSU LIMITED Patent Department, Nakahara-ku Kawasaki-shi Kanagawa 211 (JP); Ito, Takashi FUJITSU LIMITED Patent Department, Nakahara-ku Kawasaki-shi Kanagawa 211 (JP)
(74) Representative: Greenstreet, Cyril Henry

(56) References cited:
- EP-A- 0 194 569
- FR-A- 2 306 528
- US-A- 3 909 332
- US-A- 3 974 006
- JOURNAL OF VACUUM SCIENCE & TECHNOLOGY/A ,vol.3, no.3, part 1, May-June 1985, pages 714-717, Woodbury, N.Y., USA; M.TANIELIAN et al.: "Refractory metal silicide formation by sputtering a refractory metal on heated Si substrates"

## Description

A method for effecting adhesion of silicon or silicon dioxide plates.

The present invention relates to the mutual adhesion of silicon or silicon dioxide substrates for semiconductor fabrication.

During the past several years there have been many different attempts to effect mutual adhesion of silicon or silicon dioxide to increase the scale of integration of a semiconductor VLSI (Very Large Scale Integration) or for other purposes, such as fabricating high-voltage CMOS devices. Among the approaches used, three typical methods are as follows.

The first aims to effect mutual adhesion of silicon dioxide or of silicon substrates having a silicon dioxide film thereon, to produce so-called SOI (Silicon On Insulator) which enables a three-dimensional VLSI structure to be produced. In this method oxidized flat surfaces of two Si (silicon) substrates are pressed together and heated in an oxidizing atmosphere at above 700°C. The bonding mechanism is polymerization of silanol bonds between the wafers. This is reported in "Silicon-On-Insulator (SOI) by Bonding and Etch-Back" by J. B. Lasky et al., IEDM 85.

In the second method two mirror-polished and chemically hydrophilized surfaces of Si substrates are pressed together and heated in nitrogen gas at 1000°C to achieve strong adhesion. This is reported in "Lattice Configuration and Electrical Properties at the Interface of Direct Bonded Silicon" by K. Furukawa et al., Extended Abstracts of the 18th (1986 International) Conference on Solid State Devices and Materials, Tokyo, 1986. Although SOI can be produced by these methods, the high adhesion temperature of 700 to 1000°C has undesirable effects on IC chips such as those having wiring patterns thereon.

The third method is to use a PSG (Phosphorus Silicate Glass) or an organic material such as a polyimide as an adhesive to fabricate a so-called wafer-scale integration, in which many conventional IC chips are placed on and adhered to a big silicon wafer close to each other, and gaps between the IC chips are filled with an insulating material on which aluminum layer wirings are fabricated to interconnect the IC chips, or to assemble so-called three-dimensional ICs by stacking substrates on which elements are already fabricated.

In these typical methods, silicon chips/wafers or silicon dioxide films/plates have to be adhered to each other. However, in the first method, the substrate must be heated as high as 700-1000°C. The PSG can provide stable adhesion but also requires temperatures as high as 1000°C in the adhesion process. Finally the organic adhesives cannot withstand the temperature of a later wafer processing, such as a general MOS processing, and also leave a carbon contamination problem.

There is thus a need for an adhesion method in which mutual adhesion of silicon, silicon dioxide or silicon having a silicon dioxide film thereon is effected at a temperature low enough not to damage the fabricated elements, and in which no harmful effects remain after the adhesion process.

US-A-3 909 332 discloses a bonding process for single-crystal silicon substrates. One or both substrates is provided with a thin SiO₂ layer and a thicker deposited boric oxide-silicon dioxide glass bonding layer. The substrates are bonded by melting the bonding layer under pressure and at a temperature low enough not to affect previously-fabricated components.

"Journal of Vacuum Science and Technology", A3(3), May-June 1985, pages 714-717, discloses a process of refractory metal silicide formation by sputtering a refractory metal on heated Si substrates, for use in forming self-aligned silicided MOS transistors.

According to a first aspect of the invention, there is provided a method for adhering a first plate made of a material containing silicon as a major component, to a second plate made of a material containing silicon as a major component, comprising the steps of:
forming a bonding film on a surface of the first plate;
stacking the first plate tightly on a surface of the second plate with said bonding film facing said second plate; and
heating said stacked first and second plates to adhere the same, in a predetermined atmosphere and at a predetermined temperature low enough not to damage fabricated elements, if any, on said first and/or second plates;
characterised in that said bonding film is made of a refractory metal which is reactive with the materials of said plates, whereby in said heating step the refractory metal is changed to silicide, which silicide adheres the plates together.

According to a second aspect of the invention, there is provided a semiconductor device, comprising first and second plates each containing silicon as a major component, said plates having a structure in which they are stacked on one another and adhered together by means of an intermediate layer; characterised in that said intermediate layer comprises a refractory metal silicide which acts to adhere the plates together.

Thus, an embodiment of the present invention may provide a reliable adhesion method which is capable of effecting mutual adhesion of silicon (Si), silicon dioxide (SiO₂), or Si having an SiO₂ layer thereon at a temperature low enough not to damage fabricated elements thereon during the adhesion process or to leave harmful effects after the adhesion process.

In an embodiment of the present invention, mutual adhesion of Si or SiO₂ is effected by forming a metal silicide layer on each surface to be adhered. The steps of the adhesion method are as follows:-
(1) A refractory metal film, such as zirconium (Zr), is deposited, for example, by DC magnetron sputtering, on a surface of a first plate made of Si, SiO₂ or Si having SiO₂ film thereon;
(2) With the deposited film facing towards a second plate made of Si, SiO₂, or Si having a SiO₂ film thereon, the first plate is tightly stacked on the second plate;
(3) The stacked plates are heated at approximately 650°C in an inert atmosphere, such as argon gas containing 4% hydrogen. The deposited zirconium diffuses into both the plates forming a metal silicide alloy, and the silicide alloys on the two surfaces unite, acting as an adhesive agent. If the plate consists of, or is coated with, a film of SiO₂, the Zr reduces the Si dioxide and bonds with the reduced Si to form silicide.

The refractory metal is advantageously titanium, zirconium or hafnium.

The invention will now be described in more detail by way of example with reference to the accompanying drawings, in which:
Fig. 1 shows sheet resistance of a Zr film forming a silicide layer as a function of the heating temperature.
Fig.2 shows a plot of the heats of formation of various refractory metals.
Figs. 3a to 3d schematically illustrate the steps for effecting adhesion of Si to Si according to the present invention.
Figs. 4a to 4c schematically illustrate the steps for effecting adhesion of SiO₂ to SiO₂ according to the present invention.
Figs. 5a to 5c schematically illustrate the steps for effecting adhesion of Si to an Si substrate having a SiO2 film thereon according to the present invention.
Fig. 6 schematically illustrates the lattice structure of bonding Si by Zr according to the present invention.
Fig. 7 schematically illustrates the lattice structure of bonding Si to SiO₂ by Zr according to the present invention.
Fig. 8 shows the sheet resistance of a Zr film forming a silicide layer as a function of the H₂ content in Ar.
Fig. 9 shows the sheet resistance of a Zr film forming a silicide layer as a function of the heating time.
Figs. 10a to 10d show steps in the fabrication of SOI according to the present invention. Figs. 11 show the structure of a wafer-scale LSI according to the present invention. Fig. 11a is the plan view, and Fig. 11b is the cross-sectional view.
Figs. 12a to 12i show steps in the fabrication of a three-dimensional IC according to the present invention.

Photo 1 shows an SEM photograph of a cross sectional adhered portion of Si to Si by Zr.

Before describing specific embodiments of the invention some fundamental properties and the reaction mechanism of metal silicide formation will be described.

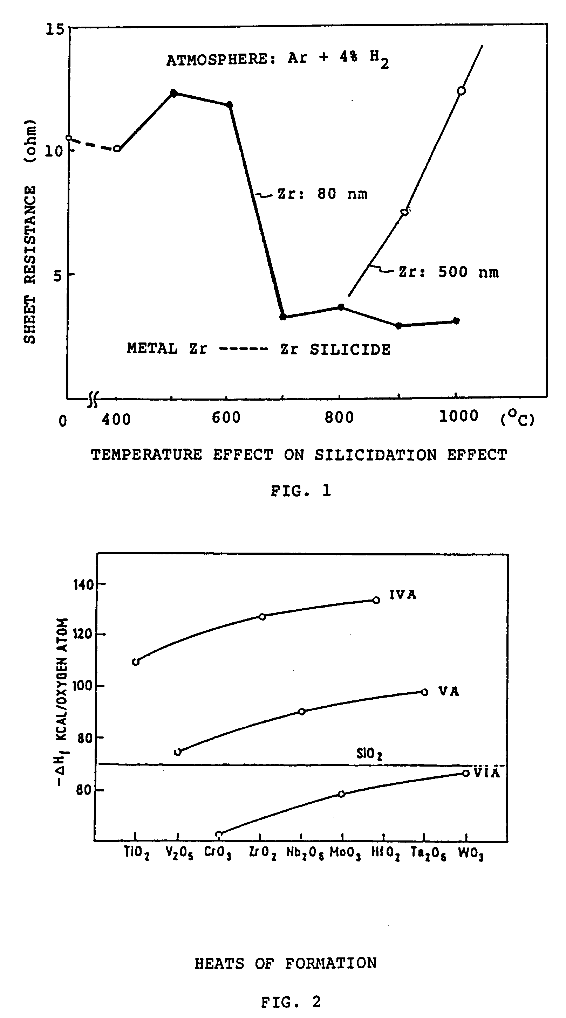

As is well known, metal silicides have been employed as conductors on ICs, and their properties have been extensively investigated and reported. Metal silicides are alloys produced by diffusion of the metals into Si at an elevated temperature. In accordance with the present invention such silicide alloys are used as adhesive agents. The temperatures for forming silicides have been reported as 500°C for molybdenum, 600°C for hafnium, 650°C for tantalum, 650°C for tungsten and so on. As representative of the refractory metals, the temperature dependence of the formation of zirconium silicide is shown in Fig. 1, which was measured by the inventor. Sheet resistance Rs is plotted as ordinate as a measure of the conversion of the Zr film into Zr silicide, because the resistivity of Zr silicide is much lower than that of metallic Zr.

As for formation of metal silicide with silicon dioxide, heats of formation have been investigated and reported, for example, as shown in Fig. 2, which is from "Silicides for VLSI Application" by S. P. Murarka, published by Academic Press, 1983. This figure is a plot of the heats of formation ( Δ H_{f}) per oxygen atom of various oxides of groups IVa, Va and VIa elements. For comparison, the Δ H_{f} value for vitreous SiO₂ is shown as a line parallel to the abscissa. Refractory metals which can reduce silicon dioxide, SiO₂, are those metals having a heat of formation the negative value of which is larger than the heat of formation of SiO₂, namely the metals of the group IVa and the group Va, as can be seen from Fig. 2. Among these metals, in particular, titanium (Ti), Zirconium (Zr) and hafnium (Hf) are very reactive with SiO₂, resulting in good adhesion. The reaction mechanism is explained by the following equations, where x and y denote the number of the respective atoms. Thus ZrO_{y} means ZrO, ZrO₂, and so on, while ZrSiₓ means ZrSi, ZrSi₂, and so on:

SiO₂ + y Zr --> Si + y ZrO_{2/y} (1)

x Si + n Zr --> ZrₙSiₓ (2)

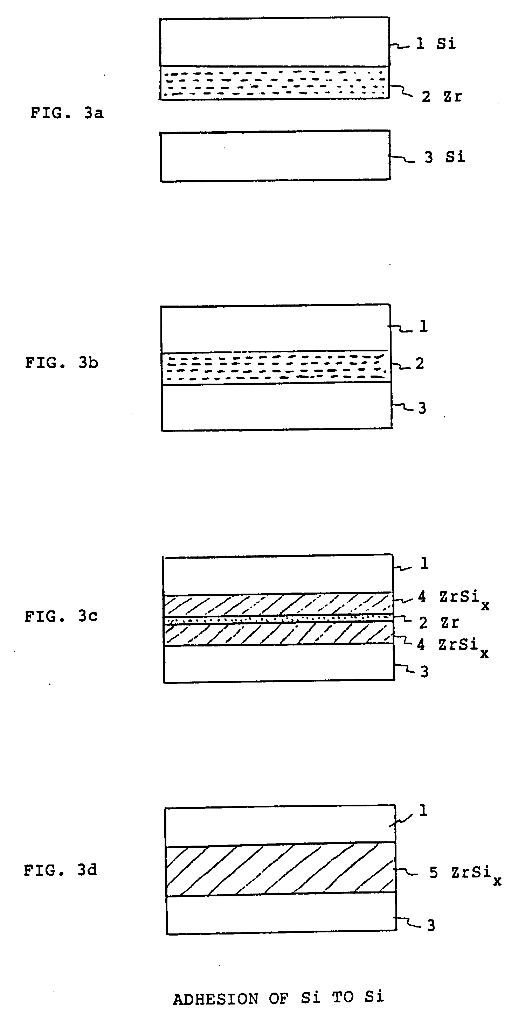

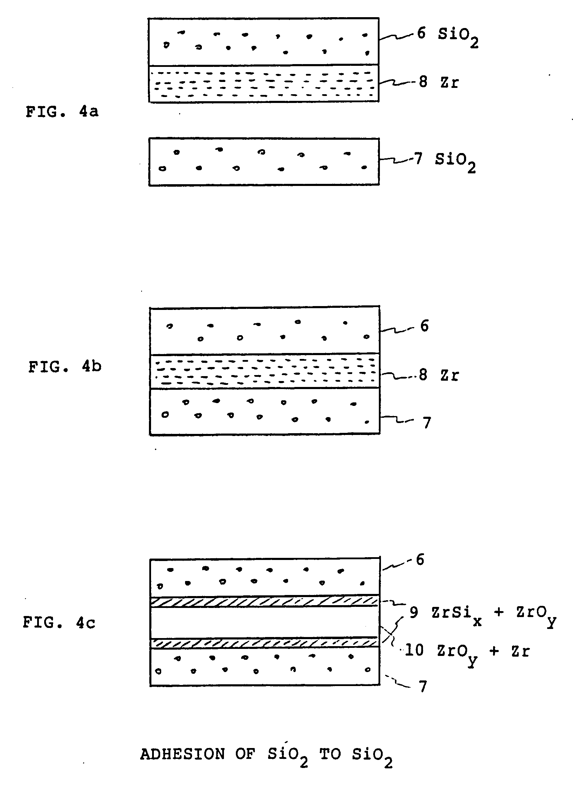

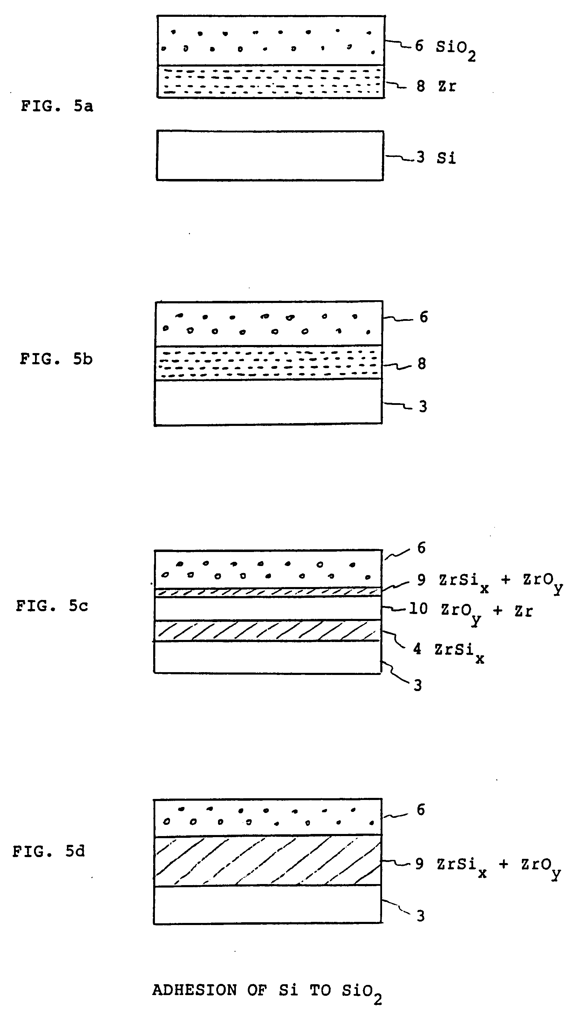

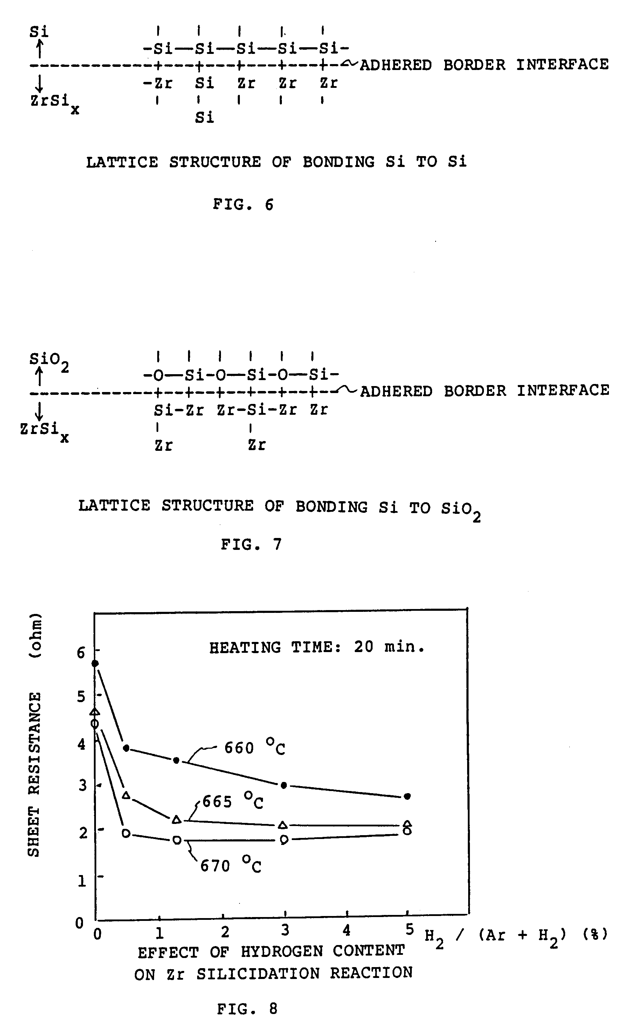

The reactions go in the direction of the arrows, because the state having the larger negative value of heat of formation is the stabler thermodynamically; Hence the reaction goes from the SiO₂ side to the side of formation of ZrO_{2/y} as shown in the equation (1), which means that SiO₂ is reduced by Zr to form Si and ZrO_{2/y}. The Si then reacts with Zr to form zirconium silicide, ZrₙSiₓ. Details of the adhesion process, in which Zr is used for forming adhesive silicide layer, will be described hereinafter for each combination of the substrate types to be adhered.
(A) The process of effecting adhesion of Si to Si is schematically illustrated in Figs. 3a through 3d. As shown in Fig. 3a, Zr is deposited on a flat surface of a silicon substrate 1 by, for example, a DC magnetron sputtering method to form a film 2 approximately 130 nm thick. The substrate 1 bearing the Zr film is turned over and stacked on the other flat Si substrate 3, as shown in Fig. 3b, sandwiching the Zr film tightly between these two Si substrates. Next, the stacks 1-3 are heated at 650°C in an atmosphere of Ar (argon gas) containing 4% H₂ (hydrogen gas) for approximately 30 minutes. Zr silicide (ZrSiₓ) is then formed as an alloy in both the Si substrates 1 and 3 as shown in Fig. 3c and this reaction proceeds until finally all of the Zr film 2 is converted into silicide alloy 5 as shown in Fig. 3d. The Zr silicide layer 5, which is approximately twice as thick as the original Zr film 2, thus acts as an adhesive agent to strongly bond the two Si substrates 1 and 3 to each other. The lattice structure of the bonding is schematically illustrated in Fig. 6. As is seen in the Figure, Si atoms in the Si substrate and Zr atoms in the silicide form Si-Zr bonds. Good adhesion is achieved even if the metal Zr remains unconverted into the silicide.
(B) The process of effecting adhesion of SiO₂ to SiO₂ is schematically illustrated in Figs. 4a to 4c. The adhesion procedure is basically the same as that of the adhesion of Si to Si. However, at the boundary surface between the Zr and the SiO₂ the reducing reaction given by the equation (1) and silicidizing reaction given by the equation (2) take place simultaneously. As shown in Fig. 4c, ZrO_{2/y} produced by equation (1) diffuses into the metal Zr layer, and the ZrO_{2/y} does not prevent the silicide reaction but slows the speed of silicidizing reaction. The lattice structure of the bonding is shown in Fig. 7. It is not necessary to convert all of the deposited Zr into silicide, and the adhesion can be achieved as long as Si-Zr or O-Zr bonds are formed. O-Zr remaining in the metal Zr causes no harmful effect.
(C) The process of effecting adhesion of Si to SiO₂ is schematically illustrated in Figs. 5a to 5d. However, the adhesion mechanism is the same as those explained in above (A) and (B).

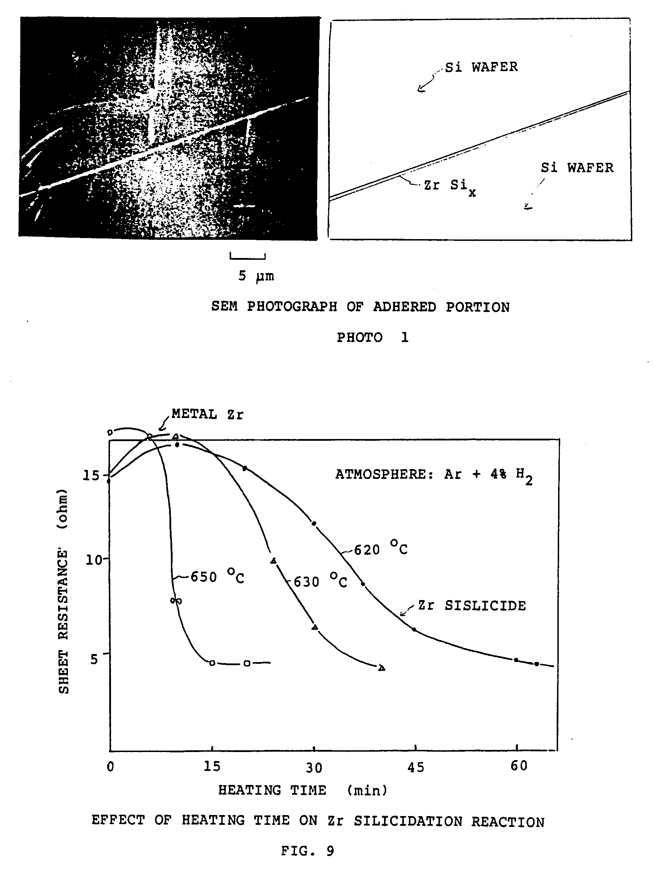

Heating conditions will be described hereinafter. It is observed in Fig. 1 that the silicide, ZrSi₂, is formed at temperatures higher than 600°C. In addition a reducing reaction also begins to take place at approximately 600°C, though the reaction is slow. Therefore a temperature of at least approximately 600°C is required for adhesion process. The thin line in Fig. 1 indicates the sheet resistance of the silicide formed, when the Zr film is 500 nm thick. The increase of the resistance at temperatures above 850°C seems to indicate that the silicide layer formed is finely cracked as a result of thermal stress. The Zr film must therefore be less than 500 nm thick for temperatures above 800°C. The atmosphere is also important. The effect of H₂ content is shown in Fig. 8, where the resistance of silicide formed from a 130 nm Zr film on a Si substrate on heating for 20 minutes in an Ar atmosphere containing H₂ at various temperatures is plotted in relation to the H₂ content of the Ar atmosphere. As is seen in the Figure, the silicidation reaction is accelerated by H₂ contents of more than approximately 0.5%. As for the effect of the heating time, data obtained by the inventor are shown in Fig. 9, where the sheet resistance, as a measure of silicide formation, is plotted as function of heating time, for different heating temperatures, in Ar containing 4% H₂. A summary of the most preferable conditions for most effective adhesion is that the atmosphere is an inert gas containing more than 0.5% of H₂, the temperature is more than 600°C, and the heating time is more than 15 minutes for a temperature of more than 650°C. A thickness of the bonding metal of less than 500 nm is preferable, but when the heating temperature is 700-800°C, the thickness is not limited. Refractory metals other than group IVa and Va can be used for adhering Si only. Even for adhering Si to Si, a IVa group metal, such as Zr, Ti and Hf is effective for reliable adhesion by evading undesirable effect of SiO₂ film which might have been naturally formed on a Si surface without being noticed.

Photo 1 is an SEM (Scanning Electron Microscope) photograph of an adhered portion of two Si wafers. A semiconductor wafer specimen was prepared by depositing a 200 nm thick Zr film on its surface by sputtering, stacked on to another Si wafer, and heated in Ar containing 4% H₂ at 700°C for 30 minutes in an electric furnace. Perfect adhesion without any voids was observed. The specimen was tested for its durability by exposure to thermal cycling at 1000°C, which is equivalent to the temperature of later MOS processing. No peeling off was observed. This test thus confirms that this method provides perfect adhesion. A similar semiconductor wafer specimen having a 500 nm thick SiO₂ film thereon was also prepared and tested, resulting in the same good uniform adhesion.

Three different types of application of the adhesion according to the present invention will now be described.

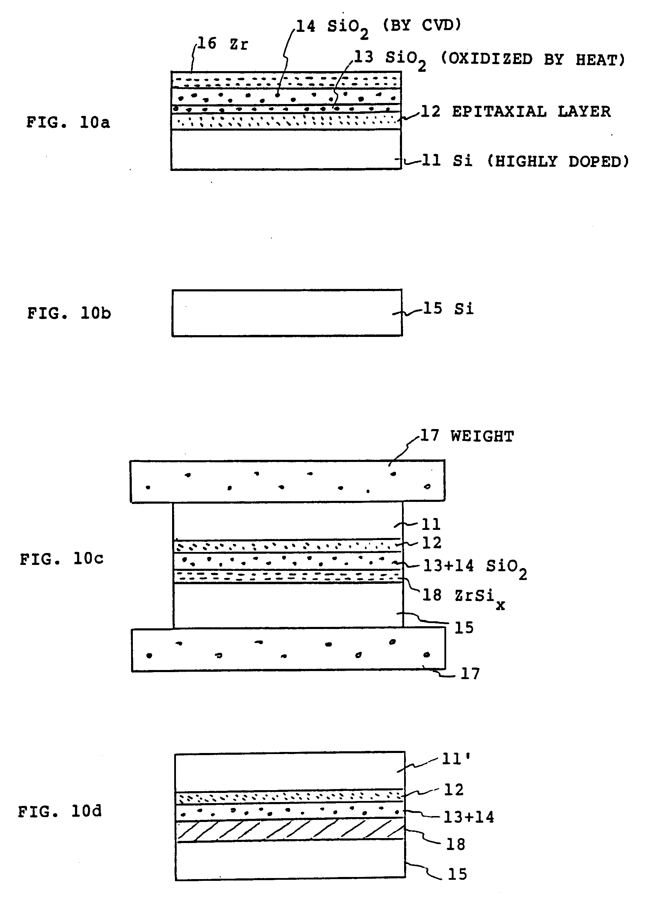

The process steps in the fabrication of an SOI are shown in Figs. 10a through 10d. Upon an Si wafer 11, having a (100) or (111) surface index and doped with As (arsenic) or other dopant at a concentration of approximately 10²⁰, a 600 nm thick epitaxial layer 12 is grown by a thermal epitaxial-growth method at 950°C in SiH₄ (monosilane gas). The surface of the epitaxial layer 12 is oxidized by a wet oxidization method to form a 100 nm thick oxide layer 13. A 1 µm thick SiO₂ layer 14 is additionally deposited thereon, by a CVD (chemical vapour deposition) method, at 450°C in O₂ (oxygen gas) and SiH₄, as shown in Fig. 10a. Upon the SiO₂ layer 14 Zr is further deposited to form a 150 nm thick film 16 by a DC magnetron sputtering method in an argon plasma at 3 x 10⁻³ Torr (0.4 Pa). Fig. 10b shows another Si wafer 15 to be adhered to the wafer 11. Next, these two wafers are stacked with the Si layer 15 facing the Zr film 16. The stacked wafers are sandwiched by two quartz plates 17 each from 2 to 10 mm thick and heated in an atmosphere of Ar containing 4% H₂ at 670°C for 2 hours. While the stack is heated, the wafers are tightly pressed against each other by the weight of the quartz plate, and the Zr film 16 is converted into silicide 18, so that the two wafers are adhered to each other as shown in Fig. 10c. The outer surface of the adhered second wafer 15 is then glued to a temporary supporting plate (not shown in the Figure) with picein or other thermoplastic adhesive material (not shown in the Figure). The temporary plate is fixed on to a lapping-polishing machine, and the outer surface of the adhered wafer 11 is removed by lapping-polishing using abrasives, such as alumina powder, to leave a several µm thick doped Si substrate 11'. The adhered and polished wafers are removed from the temporary plate by heating, and washed with a solvent, such as trichlorethylene. The remaining several µm thick Si layer 11' is etched by an etchant (8CH₃COOH + 3HNO₃ + 1HF) which is very reactive with Si doped with n⁺ or p⁺, but not reactive with Si having a concentration below 10¹⁷-10¹⁸, until the epitaxial layer 12 is exposed. In this way an SOI substrate is produced with the use of silicide as an adhesion agent. Any desired device can then be fabricated on the SOI substrate as in conventional IC fabrication.

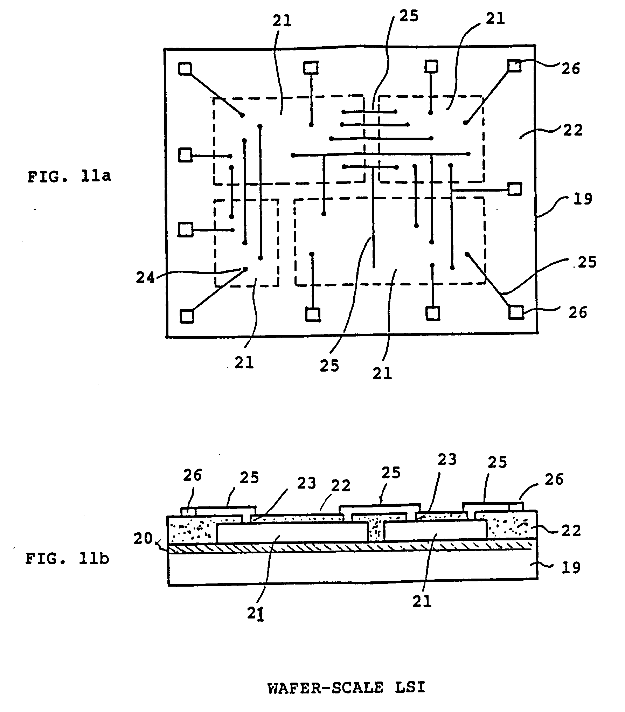

A cross-sectional view and a plan view of a wafer-scale LSI are shown in Figs. 11a and 11b. Upon a main Si substrate wafer 19 which may be as large as several inches (5 cm or more), a Zr film 20 is deposited. IC chips 21 are then placed thereon and heated until the Zr layer is converted into a silicide, so that the IC chips 21 adhere to the Si wafer 19. An insulation material such as polyimide is then applied to fill the gaps between the IC chips 21 and to coat the surfaces of the IC chips 21 to form an isolation layer 22. When the polyimide layer 22 has been coated, windows 23 are formed over terminal pads 24 on the IC chips. Next, wirings 25 are patterned over the windows 23 as well as over the polyimide layer 22 so that the adhered ICs are interconnected and connected to an outer circuit through pads 26 formed on the polyimide layer 22. An advantage of this configuration is that the thermal expansion coefficient of the IC chips and the main substrate 11 is the same, and the adhesion is perfect. Hence high density heat consumption is possible on a large sized substrate wafer, thus resulting in achieving a wafer-scale LSI.

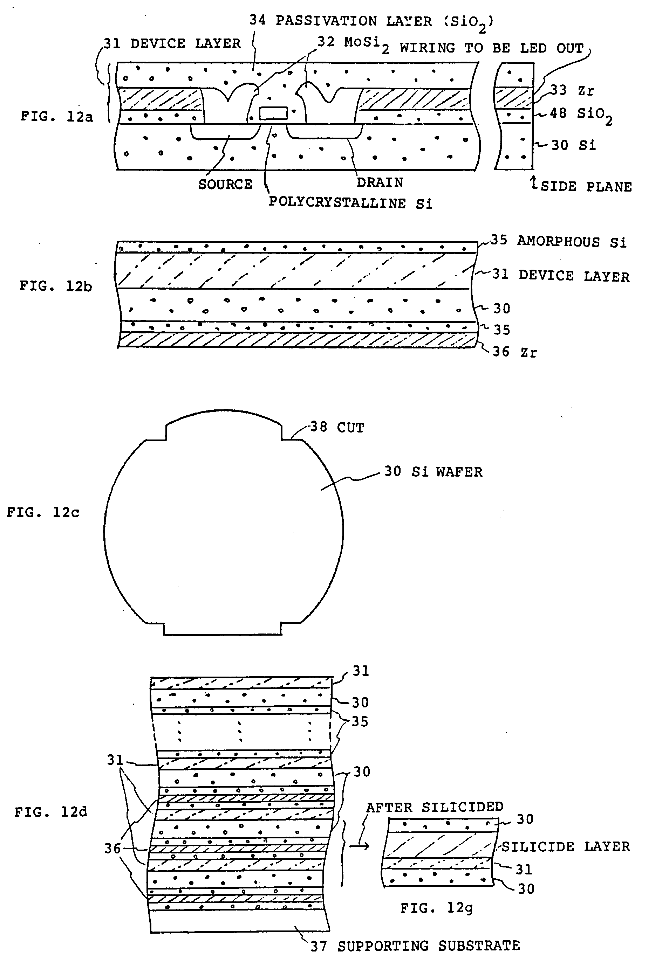

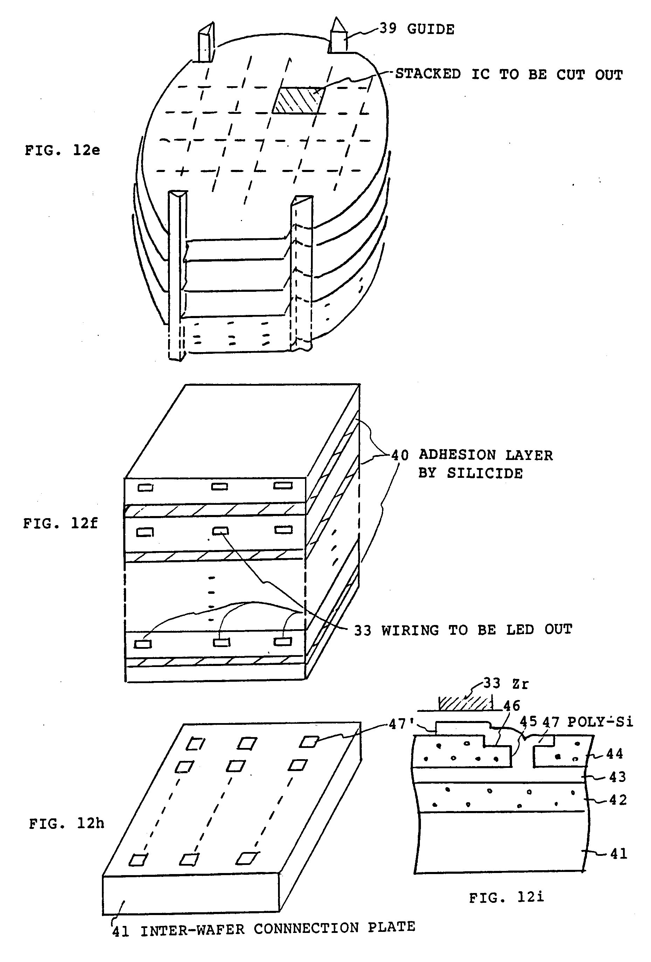

Steps in a process for fabrication of a three-dimensional IC are shown in Figs. 12a through 12g. As is shown in Fig. 12a, the desired IC devices are fabricated In a device layer 31 on a silicon wafer 30 according to conventional IC fabrication technique, except that their wiring layers are formed not with aluminum but with a refractory metal or a metal silicide, such as MoSi₂ 32 or Zr 33, so that the layer can withstand a later heat adhesion process at a temperature as high as 600°C. The Zr wiring layer 33 also acts as an adhesive agent in a later processing for inter-wafer connection. As is shown in Fig. 12a, the fundamental structure comprises a silicon wafer 30 with a device layer 31 thereon. On the device area passivation layers 34 made of SiO₂, etc., are also formed. The surface of the passivation layer 34 does not have to be strictly flat. A layer of amorphous silicon 35 as thick as approximately 100 nm is deposited upon both surfaces of the wafer 30 having the ICs, as shown in Fig. 12b, and a layer of Zr 36 as thick as approximately 150 nm is deposited upon one of the surfaces, e.g. by sputtering. Amorphous silicon is effective for accelerating silicidation and lowering the silicidation temperature.

Wafers as just described are prepared in the desired types and numbers and stacked on to each other and on a supporting substrate 37 as shown in Fig. 12d. For aligning the wafers while stacked, some cuts 38 may be previously provided at corners of each wafer, as shown in Fig. 12c, and aligned by guides 39 as shown in Fig. 12e. A quartz plate 10 to 15 mm thick (not shown in the Figure) is placed on the top of the stacked wafers as a weight, and the stacks are heated in an atmosphere of Ar containing 4% H₂ at 600°C for half an hour. The silicidation reaction with the amorphous Si starts gradually at 450°C, and all the wafers are adhered to each other by the formation of the silicide layers 40 as shown in Fig. 12f and Fig. 12g. Even after the Zr film 36 has been converted into silicide by reaction with the amorphous layer 35, most of the Zr wiring layer 33 remains without being silicided, because the temperature is not high enough to let all of the Zr wiring layer 33 react with the contacting SiO₂ films 34.

Next, the adhered wafers are vertically cut by a diamond cutter along the dotted line shown in Fig. 12e to obtain three-dimensional cubes. The side walls of the cut cubes are polished so that edges of the Zr wiring layers 33 are exposed. An inter-wafer connection plate 41 is also prepared as follows (see Figs. 12h and 12i). On the inter-wafer connection plate 41 made of Si, a 1µm thick SiO₂ film 42 is formed, and a polycrystalline silicon layer 43 approximately 700 nm thick and doped with impurities is further patterned thereon. An SiO₂ film 44 is further formed thereon. A contact hole 45 having a step 46 is formed in the SiO₂ film 44, as shown in Fig. 12i, which is a cross-sectional view of Fig. 12h. The contact hole 45 is filled with polycrystalline silicon 47 doped with impurities. The polycrystalline silicon 47 doped with impurities acts as an electrical conductor. A portion 47' of the polycrystalline silicon 47 is for contacting the exposed wiring layer 33 and is located to coincide with each corresponding exposed portion of the Zr wiring layer 33. The step 46 is to provide space for the polycrystalline silicon to connect the contact hole 46 and the portion 47'. As many interwafer connection plates 41 as necessary are pressed on to corresponding sides of the respective stacks and are heated in an atmosphere of Ar containing 4% H₂ at 600°C for half-an-hour so that the exposed portion of Zr wiring 33 forms silicide with the polycrystalline silicon 47', whereby the inter-wafer plate(s) 41 is or are adhered to the stacks and electrical connections between the stacked wafers are established. Connection to an external circuit can be made by wire bonding of bonding pads or in any other appropriate way using conventional techniques. The Zr silicide adhesion layers 40 can be used also as an electrical shield between the stacked wafers and can be connected to a ground potential.

Although in the above-described embodiments and applications of the present invention Zr is employed for forming silicide, other refractory metals, such as Ti or Hf, can be employed for adhering Si and/or SiO₂, and other refractory metals, further including molybdenum or tungsten and so on, can be employed for adhering Si to Si.

Although in the above-described embodiments and applications of the present invention Ar gas containing 4% H₂ is employed for the inert gas, other inert gases or vacuum can also be employed for the same purpose.

Summarizing the advantages of the present invention, the adhesion is carried out at a temperature as low as 650°C, but the adhesion can withstand temperatures as high as 1000°C for the later processing. The surfaces to be adhered do not required to be previously chemically treated or to be completely flat like a mirror. The surfaces are therefore not so sensitive to dust as is the case with direct bonding according to the prior art. Thus stable and reliable adhesion can be achieved in mass production without strict process control.

## Claims

1. A method for adhering a first plate (1,6) made of a material containing silicon as a major component, to a second plate (3,7) made of a material containing silicon as a major component, comprising the steps of:
forming a bonding film (2,8) on a surface of the first plate (1,6);
stacking the first plate (1,6) tightly on a surface of the second plate (3,7) with said bonding film (2,8) facing said second plate (3,7); and
heating said stacked first and second plates to adhere the same, in a predetermined atmosphere and at a predetermined temperature low enough not to damage fabricated elements, if any, on said first and/or second plates;
characterised in that said bonding film (2,8) is made of a refractory metal which is reactive with the materials of said plates, whereby in said heating step the refractory metal is changed to silicide (5,9), which silicide adheres the plates together.

2. A method according to claim 1, wherein said refractory metal is selected from the group IVa metals titanium, zirconium and hafnium.

3. A method according to claim 1 or 2, wherein said predetermined atmosphere comprises inert atmosphere means.

4. A method according to claim 3, wherein said inert atmosphere means is an inert gas.

5. A method according to claim 3, wherein said inert atmosphere means is a vacuum.

6. A method according to claim 3, 4 or 5, wherein said predetermined atmosphere further comprises hydrogen.

7. A method according to claim 6 as appended to claim 4, wherein said predetermined atmosphere is argon gas containing more than 0.5% of hydrogen gas by volume.

8. A method according to any preceding claim, wherein said refractory metal film (2,8) is from 10 to 1000 nm thick.

9. A method according to any preceding claim, wherein said refractory metal is formed by sputtering.

10. A method according to any preceding claim, wherein said first and second plates are semiconductor substrates.

11. A method according to any preceding claim, wherein one or both of said first and second plates consists of silicon, silicon dioxide, or silicon having a silicon dioxide film thereon.

12. A semiconductor device, comprising first (1,6) and second plates (3,7) each containing silicon as a major component, said plates having a structure in which they are stacked on one another and adhered together by means of an intermediate layer (2,8); characterised in that said intermediate layer (2,8) comprises a refractory metal silicide (5,9) which acts to adhere the plates together.

13. A semiconductor device according to claim 12, wherein said refractory metal is titanium, zirconium or hafnium.

14. A semiconductor device according to claim 12 or claim 13, wherein one or both of said first and second plates consists of silicon, silicon dioxide, or silicon having a silicon dioxide film thereon.

## Patentansprüche

1. Verfahren zur Befestigung einer ersten Platte (1,6), die aus einem Material mit Silicium als Hauptkomponente besteht, an eine zweite Platte (3,7), die aus einem Material mit Silicium als Hauptkomponente besteht, umfassend
das Ausbilden eines Klebefilms (2,8) auf einer Oberfläche der ersten Platte (1,6);
das Aufstapeln der ersten Platte (1,6) fest auf eine Oberfläche der zweiten Platte (3,7), wobei der Klebefilm (2,8) zur zweiten Platte (3,7) zeigt; und
das Erwärmen der aufeinandergestapelten ersten und zweiten Platten, um diese zu binden, bei einer vorbestimmten Umgebung und bei einer vorbestimmten Temperatur, die so niedrig ist, daß sie die auf der ersten und/oder zweiten Platte hergestellten Elemente, falls vorhanden, nicht beschädigt; dadurch gekennzeichnet,
daß der Klebefilm (2,8) aus einem feuerfesten Metall besteht, das sich mit dem Material der Platten umsetzt, so daß beim Heizschritt das feuerfeste Material zu einem Silicid (5,9), das die Platten aneinander befestigt, umgewandelt wird.

2. Verfahren nach Anspruch 1, wobei das feuerfeste Metall ausgewählt ist aus den IVa-Gruppen-Metallen Titan, Zirkon und Hafnium.

3. Verfahren nach Anspruch 1 oder 2, wobei die vorbestimmte Umgebung eine Inertgaseinrichtung umfaßt.

4. Verfahren nach Anspruch 3, wobei die Inertumgebung ein Inertgas ist.

5. Verfahren nach Anspruch 3, wobei die Inertumgebung ein Vakuum ist.

6. Verfahren nach Anspruch 3, 4 oder 5, wobei die vorbestimmte Umgebung weiter Wasserstoff beinhaltet.

7. Verfahren nach Anspruch 6, wenn abhängig von Anspruch 4, wobei die vorbestimmte Umgebung ein Argongas ist, das nicht mehr als 0,5 Vol.% Wasserstoffgas enthält.

8. Verfahren nach irgendeinem vorhergehenden Anspruch, wobei der feuerfeste Metallfilm (2,8) 10 bis 1000 nm dick ist.

9. Verfahren nach irgendeinem vorhergehenden Anspruch, wobei das feuerfeste Material durch Sputtering aufgebracht ist.

10. Verfahren nach irgendeinem vorhergehenden Anspruch, wobei die erste und die zweite Platte Halbleitersubstrate sind.

11. Verfahren nach irgendeinem vorhergehenden Anspruch, wobei die erste und/oder die zweite Platte aus Silicium, Siliciumdioxid oder aus Silicium mit einem Siliciumdioxidfilm darauf besteht.

12. Halbleitervorrichtung, beinhaltend eine erste (1,6) und eine zweite Platte (3,7), die jeweils Silicium als Hauptkomponente enthalten, wobei die Platten so aufgebaut sind, daß sie aufeinandergestapelt und mit einer Zwischenschicht (2,8) aneinanderbefestigt sind, dadurch gekennzeichnet,
daß die Zwischenschicht (2,8) ein feuerfestes Metallsilicid (5,9) aufweist, das die Platten aneinander bindet.

13. Halbleitervorrichtung nach Anspruch 12, wobei das feuerfeste Metall Titan, Zirkon oder Hafnium ist.

14. Halbleitervorrichtung nach Anspruch 12 oder 13, wobei die erste oder die zweite Platte oder beide aus Silicium, Siliciumdioxid oder Silicium mit einem Siliciumdioxidfilm darauf besteht.

## Revendications

1. Procédé pour coller une première plaque (1, 6) faite d'une matière contenant du silicium comme composant principal à une seconde plaque (3, 7) faite d'une matière contenant du silicium comme composant principal, comprenant les étapes :
de formation d'un film de liaison (2, 8) sur une surface de la première plaque (1, 6) ;
d'empilement de la première plaque (1, 6) étroitement serrée sur une surface de la seconde plaque (3, 7), ledit film de liaison (2, 8) faisant face à ladite seconde plaque (3, 7) ; et,
de chauffage desdites première et seconde plaques empilées, pour les coller, dans une atmosphère prédéterminée et à une température prédéterminée suffisamment basse pour ne pas endommager les éléments fabriqués, s'il y en a, sur lesdites première et/ou seconde plaques ;
caractérisé en ce que ledit film de liaison (2, 8) est fait d'un métal réfractaire qui réagit avec les matières desdites plaques, ce par quoi, lors de ladite étape de chauffage, le métal réfractaire est transformé en siliciure (5, 9), lequel siliciure colle les plaques ensemble.

2. Procédé selon la revendication 1, dans lequel ledit métal réfractaire est choisi parmi les métaux du groupe IVa, le titane, le zirconium et l'hafnium.

3. Procédé selon la revendication 1 ou 2, dans lequel ladite atmosphère prédéterminée comprend un moyen formant atmosphère inerte.

4. Procédé selon la revendication 3, dans lequel ledit moyen formant atmosphère inerte est un gaz inerte.

5. Procédé selon la revendication 3, dans lequel ledit moyen formant atmosphère inerte est le vide.

6. Procédé selon la revendication 3, 4 ou 5, dans lequel ladite atmosphère prédéterminée comprend en outre de l'hydrogène.

7. Procédé selon la revendication 6, lorsqu'elle dépend de la 4, dans lequel ladite atmosphère prédéterminée est du gaz argon contenant, en volume, plus de 0,5 % de gaz hydrogène.

8. Procédé selon l'une quelconque des revendications précédentes, dans lequel ledit film métallique réfractaire (2, 8) va de 10 à 1.000 nm d'épaisseur.

9. Procédé selon l'une quelconque des revendications précédentes, dans lequel ledit métal réfractaire est formé par pulvérisation.

10. Procédé selon l'une quelconque des revendications précédentes, dans lesquels lesdites première et seconde plaques sont des substrats semi-conducteurs.

11. Procédé selon l'une quelconque des revendications précédentes, dans lequel l'une, ou les deux, desdites première et seconde plaques est constituée, ou sont constituées, de silicium, de dioxyde de silicium, ou de silicium portant un film de dioxyde de silicium.

12. Dispositif à semi-conducteurs, comprenant des première (1, 6) et seconde (3,7) plaques chacune contenant du silicium comme composant principal, lesdites plaques ayant une structure dans laquelle elles sont empilées les unes sur les autres, et collées ensemble au moyen d'une couche (2, 8) ; caractérisé en ce que ladite couche (2, 8) comprend un siliciure de métal réfractaire (5, 9) qui agit pour coller les plaques ensemble.

13. Dispositif à semi-conducteurs selon la revendication 12, dans lequel ledit métal réfractaire est le titane, le zirconium ou l'hafnium.

14. Dispositif à semi-conducteurs selon la revendication 12, ou la revendication 13, dans lequel l'une, ou les deux, desdites première et seconde plaques est constituée, ou sont constituées, de silicium, de dioxyde de silicium, ou de silicium portant un film de dioxyde de silicium.
